# EUROPÄISCHE PATENTANMELDUNG

(11) **EP 1 282 235 A2**
(43) Veröffentlichungstag der Anmeldung: **05.02.2003**
(21) Anmeldenummer: 02012035.8
(22) Anmeldetag: 31.05.2002
(51) Int. Cl.: H03M 1/06, H03M 1/74

(54) **Anordnung und Verfahren zur Digital-/Analogumsetzung**

(30) Priorität: 26.07.2001 DE 10136440
(71) Anmelder: ROBERT BOSCH GMBH, 70442 Stuttgart (DE)
(72) Erfinder: Lehr, Carsten, 30169 Hannover (DE); Nyenhuis, Detlev, 31079 Sibbesse (DE)

(57) **Zusammenfassung**

Vorgeschlagen werden eine Anordnung und ein Verfahren zur Umsetzung einer diskreten Wertefolge in ein analoges Signal mit einer Mehrzahl im wesentlichen gleicher schaltbarer Quellen, die derart miteinander verbunden sind, dass sich ihre Ausgangssignale zu dem analogen Signal überlagern, mit einer Zuordnungsschaltung zur Zuordnung von Schaltzuständen der Quellen zu Werten der diskreten Wertefolge in Abhängigkeit sowohl der Werte der diskreten Wertefolge als auch vorangegangener Schaltzustände der schaltbaren Quellen, die oder das sich erfindungsgemäß dadurch auszeichnet, dass mindestens eine Mehrzahl der, insbesondere alle, Quellen mindestens drei voneinander verschiedene Schaltzustände aufweisen.

Gegenüber bekannten DWA-Systemen hat die Erfindung den Vorteil, dass ein bestimmter Wert K durch verschiedene Anzahl eingeschalteter Quellen darstellbar ist, so dass durch Streuungen in den Ausgangssignalen der Quellen untereinander verursachte Verzerrungen bzw. Fehler im analogen Ausgangssignal weniger stark hervortreten.

## Beschreibung

### Stand der Technik

Die Erfindung geht von einer Anordnung und einem Verfahren zur Umsetzung einer diskreten Wertefolge in ein analoges Signal nach der Gattung der unabhängigen Patentansprüche aus.

In der Audiosignalverarbeitung werden zunehmend sogenannte σ/δ-Digital-/Analog-Wandler, nachfolgend kurz σ/δ-D/A-Wandler zur Umsetzung digital verarbeiteter Audiosignale in ein wiedergebbares analoges Audiosignal eingesetzt. Dabei erzeugt ein σ/δ-Converter einen Einbit- oder Mehrbit-Datenstrom, der zur Ansteuerung einer oder mehrerer Quellen, zum Beispiel Stromquellen, verwendet wird. Mehrbit-Wandler haben gegenüber Einbit-Wandlern den Vorteil, dass sie mit einer geringeren Abtastrate betrieben werden können. Im Falle eines Mehrbit-Datenstroms werden mehrere parallel geschaltete, im wesentlichen gleiche Stromquellen in Abhängigkeit des Mehrbit-Eingangssignals angesteuert und die Signale der Stromquellen zu einem gemeinsamen analogen Ausgangssignal überlagert. Eine Schwierigkeit bei der Verwendung von Mehrbit-Wandlern besteht darin, dass die verwendeten Stromquellen aufgrund unvermeidbarer Toleranzen nie den exakt gleichen Strom abgeben. Bei einer festen Zuordnung von Stromquellen zu Ausgangswerten des σ/δ-Converters kommt es demzufolge zu nichtlinearen Verzerrungen im Ausgangssignal, die sich insbesondere im Falle eines Audiosignals als Ausgangssignal störend bemerkbar machen. In Norsworthy, S.R.; Schreier, R.; Temes, G.C.: Delta-Sigma Data Converters: Theory, Design, and Simulation. IEEE Press 1996 wird ausgeführt, dass es möglich ist, mit einer "Data Weighted Averaging (DWA)"-Schaltung ein sogenanntes "noise-shaping"-Prinzip auf die durch oben beschriebenes nicht ideales Verhalten der Stromquellen verursachten Fehler anzuwenden. Dabei wird eine feste Zuordnung der Stromquellen zu Ausgangswerten des σ/δ-Converters durch eine Schaltung ersetzt, die die Auswahl der zu einem bestimmten Abtastzeitpunkt einzuschaltenden Stromquellen in Abhängigkeit davon steuert, welche Stromquellen zu vorhergehenden Abtastzeitpunkten eingeschaltet worden sind.

Bei bisher bekannten DWA-Systemen wird von D/A-Wandlern ausgegangen, deren Stromquellen nur zwei Schaltzustände, nämlich "Strom ein" oder "Strom aus", annehmen können. Bei diesen Systemen wird ein Wert K durch das Einschalten von genau K Stromquellen dargestellt.

### Vorteile der Erfindung

Die erfindungsgemäße Anordnung und das erfindungsgemäße Verfahren zur Umsetzung einer diskreten Wertefolge in ein analoges Signal mit den Merkmalen der unabhängigen Patentansprüche haben demgegenüber den Vorteil, dass ein- und derselbe Wert K, sofern nur genügend ansteuerbare Stromquellen zur Verfügung stehen, auf verschiedenen Arten, nämlich durch verschiedene Anzahlen eingeschalteter (Strom-) Quellen dargestellt werden kann.

Dazu ist eine Anordnung zur Umsetzung einer diskreten Wertefolge in ein analoges Signal mit einer Mehrzahl im wesentlichen gleicher schaltbarer Quellen, die derart miteinander verbunden sind, dass sich ihre Ausgangssignale zu dem analogen Signal überlagern, mit einer Zuordnungsschaltung zur Zuordnung von Schaltzuständen der Quellen zu Werten der diskreten Wertefolge in Abhängigkeit sowohl der Werte der diskreten Wertefolge als auch vorangegangener Schaltzustände der schaltbaren Quellen erfindungsgemäß derart ausgebildet, dass mindestens eine Mehrzahl der, insbesondere alle, Quellen mindestens drei voneinander verschiedene Schaltzustände aufweisen.

Analog ist ein Verfahren zur Umsetzung einer diskreten Wertefolge in ein analoges Signal, wobei das analoge Signal aus den Ausgangssignalen einer Mehrzahl im wesentlichen gleicher schaltbarer Quellen überlagert wird, und wobei eine Zuordnung von Schaltzuständen der Quellen zu Werten der diskreten Wertefolge in Abhängigkeit sowohl der Werte der diskreten Wertefolge, als auch vorangegangener Schaltzustände der schaltbaren Quellen erfolgt, erfindungsgemäß derart ausgebildet, dass mindestens eine Mehrzahl der, insbesonderer alle, Quellen mindestens drei voneinander verschiedene Schaltzustände annehmen können.

Eine erfindungsgemäße Anordnung sowie ein erfindungsgemäßes Verfahren ermöglichen die Darstellung ein- und desselben Wertes K zum einen durch Einschalten von K Quellen mit positivem Ausgangssignal, falls K > 0 ist, bzw. K Quellen mit negativem Ausgangssignal, falls K < 0 ist, zum anderen durch Einschalten von Kₚ Stromquellen mit positivem Ausgangssignal und Kₙ Stromquellen mit negativem Ausgangssignal mit K = Kₚ - Kₙ. Im zweiten Fall werden also zur Darstellung eines Wertes K mehr als K Quellen eingeschaltet. Dadurch ist ein besserer Ausgleich der oben beschriebenen Abweichungen der Quellen untereinander möglich. Mit Hilfe der erfindungsgemäßen DWA-Variante wird somit ein verbessertes Gesamtverhalten eines erfindungsgemäß ausgestatteten σ/δ-D/A-Wandlers im Hinblick auf die Ausgangssignalverzerrungen erreicht.

Vorteilhafte Ausführungsformen und Weiterbildungen der Erfindung sind in den abhängigen Patentansprüchen angegeben. Eine vorteilhafte Ausführungsform der Erfindung richtet sich darauf, dass ein erster Schaltzustand in einem positiven Ausgangssignal einer Quelle, ein zweiter Schaltzustand in einem negativen, betragsgleichen Ausgangssignal der Quelle und ein dritter Schaltzustand in einem Ausgangssignal der Höhe 0 der Quelle besteht.

Dies hat den besonderen Vorteil, dass der dritte Schaltzustand, "O", tatsächlich für alle Quellen gleich ist.

Weiterhin umfaßt die erfindungsgemäße Anordnung vorteilhafterweise eine Anhebungsschaltung, mittels der eine negative Werte umfassende Wertefolge mit einem positivem Offset versehen wird, der dem Betrag des kleinsten möglichen Werts der Wertefolge entspricht.

Dies vereinfacht die Logik in den folgenden Blöcken.

Vorteilhafterweise umfaßt die erfindungsgemäße Anordnung eine Gedächtnisschaltung, vorzugsweise in Form eines Integrierers, dem die Schaltzustände der Quellen oder den Schaltzuständen der Quellen zugeordnete Zustandssignale zugeführt sind, und in Abhängigkeit von deren Inhalt neuen Werten der Wertefolge Schaltzustände der Quellen zugeordnet werden. Vorteilhafterweise umfaßt die erfindungsgemäße Anordnung eine Begrenzungsschaltung zur Begrenzung der Inhalte der Gedächtnisschaltung auf einen vorgegebenen Wertebereich durch Clipping, also durch Ersetzen eines eine Wertebereichsgrenze überschreitenden Inhalts durch die Wertsbereichgrenze und/oder durch Reduzierung der Inhalte um vorgegebene Werte, sofern alle Inhalte größer als vorgegebene Mindestwerte sind. Dies hat den besonderen Vorteil, dass ein Speicher der Gedächtnisschaltung zur Speicherung zurückliegender Schaltzustände oder durch Integration über zurückliegende Schaltzustände abgeleiteter Inhalte klein gehalten werden kann. Ebenso gestalten sich demzufolge nachfolgende Rechenoperationen einfacher.

Gemäss einer vorteilhaften Ausführungsform der Erfindung ist die genannte Zuordnungsschaltung zur Durchführung der Schritte
i) Rücksetzen den Schaltzuständen der Quellen zugeordneter Zustandssignale auf ihren Minimalwert,
ii) Auswählen derjenigen Quelle, für die die Summe aus Inhalt der Gedächtnisschaltung und aktuellem Zustandssignal den kleinsten Wert enthält und einen Höchstwert noch nicht erreicht hat,
iii) Erhöhen des Zustandssignals der ausgewählten Quelle um eine Einheit,
iv) Wiederholen der Schritte ii) und iii) [v(k)+L]-mal, sofern der Wertebereich der Wertefolge zwischen -L und +L liegt,
   oder [v(k)]-mal, sofern der Wertebereich der Wertefolge zwischen 0 und 2L liegt,
   wobei v(k) ein Wert der diskreten Wertefolge zu einem diskretem Zeitpunkt k und L eine positive ganze Zahl ist,
v) Schalten der Schaltzustände der Quellen entsprechend den ermittelten Zustandssignalen
ausgebildet.

### Zeichnungen

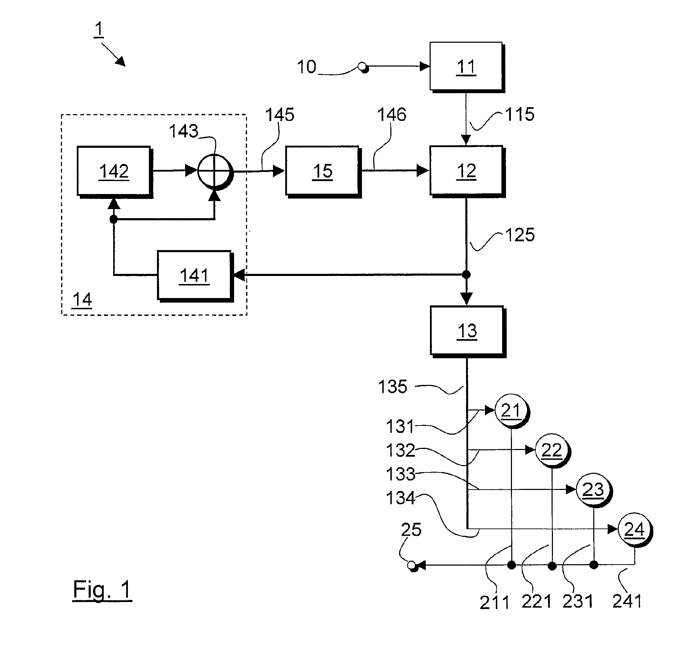

Ausführungsbeispiele der Erfindung sind in der Figur angegeben und werden nachfolgend näher erläutert.

Die Figur zeigt den Aufbau einer erfindungsgemäßen DWA-(Data Weighted Averaging)-Schaltung als Ausführungsbeispiel für eine erfindungsgemäße Umsetzungsanordnung als Teil einer Audiosignalverarbeitung, wie diese beispielsweise in für einen mobilen Einsatz vorgesehenen Audiosignalanlagen, wie beispielsweise Autoradiogeräten, Verwendung findet.

### Beschreibung der Ausführungsbeispiele

Die Figur zeigt eine bevorzugte Ausführungsform der erfindungsgemäßen Anordnung 1 zur Umsetzung einer diskreten Wertefolge, die an einem Eingang 10 der Anordnung anliegt, in ein analoges Signal, das an einem Ausgang 25 abnehmbar ist. Bei der diskreten Wertefolge handelt es sich beim vorliegenden Ausführungsbeispiel um ein digital verarbeitetes Audiosignal. Das am Ausgang 25 abnehmbare analoge Signal ist ein dem Lautsprecher einer Audioanlage deren Bestandteil in der Figur dargestellte erfindungsgemäße Anordnung ist, zuführbares analoges Audiosignal.

Das dem Eingang 10 der Anordnung zugeführte digitale Signal ist ein durch σ/δ-Konvertierung eines Audiosignals entstandenes mehrere Bit breites digitales Signal. Das digitale Eingangssignal wird nachfolgend mit dem Formelzeichen v(k) bezeichnet, wobei k einen jeweiligen diskreten Abtastzeitpunkt k bezeichnet. Das digitale Eingangssignal v(k) umfaßt einen Wertebereich diskreter Werte zwischen den Extremwerten -L und +L, wobei L für nachfolgende Betrachtungen beispielhaft gleich dem Wert 4 gesetzt wird.

In einer Anhebungsschaltung 11 wird die diskrete Wertefolge v(k) mit einem Offset von L versehen, also in einen Wertebereich zwischen den Extremwerten 0 und 2L transformiert.

Das transformierte Eingangssignal 115 ist einer Zuordnungsschaltung 12 zur Zuordnung von Schaltzuständen zur Generierung des analogen Ausgangssignals verwendeter Quellen 21, 22, 23, 24 zu Werten der diskreten Eingangsfolge zugeführt. Der Zuordnungsschaltung 12 kommt die Aufgabe zu, den Werten der diskreten Wertefolge Schaltzustände der Quellen 21, 22, 23 und 24 in Abhängigkeit sowohl der Werte der diskreten Wertefolge v(k), als auch vorangegangener Schaltzustände der schaltbaren Quellen 21, 22, 23 und 24 zuzuordnen.

Die Quellen 21, 22, 23 und 24 weisen beim vorliegenden Ausführungsbeispiel jeweils drei verschiedene Schaltzustände auf, wobei ein erster Schaltzustand in einem positiven Ausgangssignal vorgegebener Höhe, ein zweiter Schaltzustand in einem negativen betragsgleichen Ausgangssignal und ein dritter Schaltzustand in einem Ausgangssignal der Höhe 0 besteht. Die Ausgangssignale 211, 221, 231 und 241 der Quellen 21, 22, 23 und 24 überlagern sich additiv zu dem am Ausgang 25 der Anordnung abnehmbaren analogen Audiosignal. Im vorliegendem Fall handelt es sich bei den genannten Quellen um Stromquellen, so dass sich das analoge Ausgangssignal durch Addition der von den Stromquellen 21 bis 24 erzeugten Ströme nach Maßgaben derer Schaltzustände ergibt.

Alternativ können die Quellen beispielsweise auch als Spannungsquellen ausgeführt sein, die dann in Reihe geschaltet sind.

Den drei genannten Schaltzuständen sind innerhalb der DWA-Schaltung Zustandssignale svᵢ mit möglichen Werten 0, 1 und 2 zugeordnet. Diese werden mit einer Anpassungsschaltung 13 in Steuersignale 131, 132, 133 und 134 zur Ansteuerung der Quellen 21 bis 24, die zu einem Steuersignalbus 135 zusammengefaßt sind, umgesetzt.

Die in der Figur dargestellte Anordnung umfaßt weiterhin eine Gedächtnisschaltung 14, die sich im vorliegenden Fall aus einem ersten Integrierer 141, einem zweiten Integrierer 142 und einer Summationsschaltung 143 zusammensetzt. Dem ersten Integrierer sind die den Schaltzuständen der Quellen zugeordneten Zustandssignale svᵢ, wobei i die Nummer der nach Maßgabe des Zustandssignals angesteuerten Quelle 21, 22, 23 oder 24 bezeichnet, zugeführt. Der Inhalt des ersten Integrierers 141 ist dem zweiten Integrierer 142 sowie einem ersten Eingang der Summationsschaltung 143 zugeführt. Weiterhin ist der Inhalt des zweiten Integrierers 142 einem zweiten Eingang der Summationsschaltung 143 zugeführt. Die Gedächtnisschaltung 14 hat die Aufgabe, zurückliegende Werte des vektoriellen Zustandssignals sv aufzuintegrieren und zu speichern. Da gemäss vorliegender Ausführungsform die Komponenten svᵢ des vektoriellen Zustandssignals sv nur positive Werte annehmen können, würden sich durch stetige Aufintegration dieser Werte im Laufe des Betriebs der Schaltung sehr hohe Werte in der Gedächtnisschaltung 14 ergeben. Daher ist es erfindungsgemäß vorgesehen, dass die Gedächtnisschaltung 14 eine in der Figur nicht separat dargestellte Begrenzungsschaltung aufweist, die durch Clipping und/oder Reduzierung gespeicherter Werte um einen vorgegebenen Wert die gespeicherten Werte in einem vorgegebenen Wertebereich hält.

Das am Ausgang der Summierschaltung 143 und damit am Ausgang der Gedächtnisschaltung 14 anstehende vektorielle Gedächtnissignal 145 wird in einer Verzögerungsschaltung 15 nochmals verzögert. Das verzögerte vektorielle Gedächtnissignal 146 mit dem Komponenten syᵢ wobei ᵢ eine positive ganze Zahl ist, ist der Zuordnungsschaltung 12 zugeführt. In die Zuordnung von Schaltzuständen zu Werten der diskreten Wertefolge v(k) fließen somit sowohl Werte der diskreten Wertefolge, als auch nach Maßgabe der Gedächtnisschaltung verarbeitete und zusätzlich verzögerte zurückliegende Zustandssignale bzw. Schaltzustände der angesteuerten Quellen ein.

Die in der Figur fett gezeichneten Bestandteile und Verbindungen der Anordnung 1 sind vektoriell ausgeführt. Im Falle des hier angenommenen Wertebereichts zwischen -4 und 4 für das diskrete Eingangssignal v(k) existieren mithin 4 Quellen sowie eine 4 Einzelsignale breite Signalverarbeitung in dem die Blöcke 12, 13, 14 und 15 umfassenden eigentlichen DWA-System.

In der Zuordnungsschaltung wird ausgehend von dem Ausgangswert svᵢ = 0 für alle i, also für jede der L-Stromquellen diejenige Stromquelle i (21, ..., 24) ausgewählt, für die die Summe aus dem jeweiligen verzögerten Gedächtnissignal und dem jeweiligem Zustandssignal, also syᵢ + svᵢ den kleinsten Wert aufweist. Für diese Stromquelle i wird das Zustandssignal svᵢ um eine Einheit erhöht. Dieser Vorgang wird [v(k)+L]-mal wiederholt. Hat ein einer Stromquelle zugeordnetes Zustandssignal svᵢ den Maximalwert 2 erreicht, wird die zugehörige Stromquelle i nicht wieder ausgewählt. Damit ergibt sich ein vektorielles Zustandssignal sv, dessen L Komponenten in den Wertebereich zwischen den Extremwerten 0 und 2 fallen.

Die Integratoren 141 und 142 sind gemäss einer bevorzugten Ausführungsform der Erfindung derart ausgebildet, dass von ihren L Zustandsspeichern jeweils der Wert 1 abgezogen wird, solange die Werte aller Zustandsspeicher größer 0 sind. Damit wird eine Beschränkung des Wertebereichs der Zustandsspeicher der Integratoren erreicht. Zusätzlich ist ein Clipping bei Erreichen des Wertes N-1 realisiert, um für ungünstige Eingangsfolgen ein unbeschränktes Wachstum der Integratorwerte zu vermeiden.

Eine mögliche Alternative der Gedächtnisschaltung besteht darin, dass auf den zweiten Integrator 142 und demzufolge auch auf die Summierschaltung 143 verzichtet wird. Damit wird ein DWA-System erster Ordnung realisiert.

Ein DWA-System höherer Ordnung ist realisierbar, indem weitere Integratoren sowie Summierschaltungen ergänzt werden. Eine kritische Obergrenze für die Anzahl möglicher Integratoren ist dabei durch die Stabilität des Gesamtsystems gegeben.

## Patentansprüche

1. Anordnung zur Umsetzung einer diskreten Wertefolge (10) in ein analoges Signal (25)
- mit einer Mehrzahl im wesentlichen gleicher schaltbarer Quellen (21, 22, 23, 24), die derart miteinander verbunden sind, daß sich ihre Ausgangssignale (211, 221, 231, 241) zu dem analogen Signal (25) überlagern,
- mit einer Zuordnungsschaltung (12) zur Zuordnung von Schaltzuständen der Quellen (21, 22, 23, 24) zu Werten der diskreten Wertefolge (10) in Abhängigkeit
a) der Werte der diskreten Wertefolge (10) und
b) vorangegangener Schaltzustände (146) der schaltbaren Quellen (21, 22, 23, 24),
**dadurch gekennzeichnet,**
**daß** mindestens eine Mehrzahl der, insbesondere alle, Quellen (21, 22, 23, 24) mindestens drei voneinander verschiedene Schaltzustände aufweisen.

2. Anordung nach Anspruch 1, **dadurch gekennzeichnet, daß** ein erster Schaltzustand in einem positiven Ausgangssignal einer Quelle (21), ein zweiter Schaltzustand in einem negativen, betragsgleichen Ausgangssignal der Quelle (21) und ein dritter Schaltzustand in einem Ausgangssignal der Höhe NULL der Quelle (21) besteht.

3. Anordnung nach einem der vorhergehenden Ansprüche, **gekennzeichnet durch** eine Anhebungsschaltung (11), mittels der eine negative Werte umfassende Wertefolge (10) mit einem positiven Offset versehen wird, der dem Betrag des kleinsten möglichen Werts der Wertefolge (10) entspricht.

4. Anordnung nach einem der vorhergehenden Ansprüche, **gekennzeichnet durch** eine Gedächtnisschaltung (14), vorzugsweise in Form mindestens eines Integrierers (141), dem die Schaltzustände der Quellen (21, 22, 23, 24) oder den Schaltzuständen der Quellen zugeordnete Zustandssignale (125) zugeführt sind, und in Abhängigkeit von deren Inhalt (145) neuen Werten der Wertefolge Schaltzustände der Quellen (21, 22, 23, 24) zugeordnet werden.

5. Anordnung nach Anspruch 4, **gekennzeichnet durch** eine Begrenzungsschaltung zur Begrenzung der Inhalte der Gedächtnisschaltung (14) auf einen vorgegebenen Wertebereich **durch** Clipping und/oder Reduzierung der Inhalte um vorgegebene Werte, sofern die Inhalte größer als vorgegebene Mindestwerte sind.

6. Anordnung nach Anspruch 4 oder 5, **gekennzeichnet durch** eine Ausbildung der Zuordnungsschaltung (12) zur Durchführung folgender Schritte
i) Rücksetzen den Schaltzuständen der Quellen (21, 22, 23, 24) zugeordneter Zustandssignale auf ihren Minimalwert,
ii) Auswählen derjenigen Quelle, für die die Summe aus Inhalt der Gedächtnisschaltung (146) und aktuellem Zustandssignal (125) den kleinsten Wert aufweist und deren Zustandssignal einen Höchstwert noch nicht erreicht hat,
iii) Erhöhen des Zustandssignals (125) der ausgewählten Quelle um eine Einheit,
iv) Wiederholen der Schritte ii) und iii) [v(k)+L]-mal, sofern der Wertebereich der Wertefolge zwischen -L und +L liegt,
oder [v(k)]-mal, sofern der Wertebereich der Wertefolge zwischen 0 und 2L liegt,
wobei v(k) ein Wert der diskreten Wertefolge zu einem diskreten Zeitpunkt k und L eine positive ganze Zahl ist,
v) Schalten der Schaltzustände der Quellen entsprechend den ermittelten Zustandssignalen.

7. Verfahren zur Umsetzung einer diskreten Wertefolge in ein analoges Signal
- wobei das analoge Signal aus den Ausgangssignalen einer Mehrzahl im wesentlichen gleicher schaltbarer Quellen überlagert wird,
- wobei eine Zuordnung von Schaltzuständen der Quellen zu Werten der diskreten Wertefolge in Abhängigkeit
a) der Werte der diskreten Wertefolge und
b) vorangegangener Schaltzustände der schaltbaren Quellen erfolgt,
**dadurch gekennzeichnet,**
**daß** mindestens eine Mehrzahl der, insbesondere alle, Quellen mindestens drei voneinander verschiedene Schaltzustände aufweisen.

8. Verfahren nach Anspruch 7, **gekennzeichnet durch** die Schritte
i) Rücksetzen den Schaltzuständen der Quellen
zugeordneter Zustandssignale auf ihren Minimalwert, ii) Auswählen derjenigen Quelle, für die die Summe aus mindestens letztem vorangegangenem Schaltzustand und aktuellem Zustandssignal den kleinsten Wert aufweist und deren Zustandssignal einen Höchstwert noch nicht erreicht hat,
iii) Erhöhen des Zustandssignals der ausgewählten Quelle um eine Einheit,
iv) Wiederholen der Schritte ii) und iii) [v(k)+L]-mal, sofern der Wertebereich der Wertefolge zwischen -L und +L liegt,
oder [v(k)]-mal, sofern der Wertebereich der Wertefolge zwischen 0 und 2L liegt,
wobei v(k) ein Wert der diskreten Wertefolge zu einem diskreten Zeitpunkt k und L eine positive ganze Zahl ist,
v) Schalten der Schaltzustände der Quellen entsprechend den ermittelten Zustandssignalen.
